(19) Europäisches Patentamt

European Patent Office

Office européen des brevets

(11) **EP 1 507 265 B1**

(12) **EUROPEAN PATENT SPECIFICATION**

(45) Date of publication and mention
of the grant of the patent:
**12.07.2006 Bulletin 2006/28**

(51) Int Cl.:
***G11C 5/06*** (2006.01)    ***H04L 12/28*** (2006.01)

(21) Application number: **04447186.0**

(22) Date of filing: **11.08.2004**

(54) **Networked measuring system with sensors and a bridge**

Vernetztes Messsystem, das Sensoren und eine Bridge-Vorrichtung umfasst

Système de mesure en réseau comprenant des capteurs et un pont

(84) Designated Contracting States:
**AT BE BG CH CY CZ DE DK EE ES FI FR GB GR HU IE IT LI LU MC NL PL PT RO SE SI SK TR**

(30) Priority: **11.08.2003 US 494381 P**

(43) Date of publication of application:
**16.02.2005 Bulletin 2005/07**

(73) Proprietor: **VLAAMSE INSTELLING VOOR TECHNOLOGISCH ONDERZOEK (VITO) 2400 Mol (BE)**

(72) Inventor: **Coenen, Peter 3380 Glabbeek (BE)**

(74) Representative: **Van Malderen, Joëlle et al pronovem - Office Van Malderen Avenue Josse Goffin 158 1082 Bruxelles (BE)**

(56) References cited:
**EP-A- 1 096 724**

• **BRAD COSTA: "Wireless Distributed Sensing and Actuation" DOCUMENT FOR BACHELOR OF ENGINEERING, [Online] October 2002 (2002-10), XP002300386 WOLLONGONG Retrieved from the Internet: URL:http://members.optusnet.com.au/ bradcos ta/Brad_Costa_Thesis.pdf> [retrieved on 2004-10-11]**
• **DALLAS MAXIM: "Application Note 212, autoconfiguration of 1-wire systems" APPLICATION NOTES, [Online] 19 August 2002 (2002-08-19), pages 1-3, XP002300387 Retrieved from the Internet: URL:http://pdfserv.maxim- ic.com/en/an/app2 12.pdf> [retrieved on 2004-11-11]**
• **"I-BOTTON 1-WIRE HUB" SIMAT 1-WIRE WEATHER STATION PROJECT, [Online] 3 February 2002 (2002-02-03), XP002300388 Retrieved from the Internet: URL:http: //web.archive.org/web/20020203095 550/http: //www.simat.enta.net/1wirehub.htm l> [retrieved on 2004-10-11]**
• **LARNBERTI F ET AL: "Low-cost home monitoring using a java-based embedded computer" IEEE PUBLICATION, 24 April 2003 (2003-04-24), pages 342-345, XP010651579**
• **POUNDS-CORNISH A ET AL: "The iDorm - a practical deployment of Grid technology" CLUSTER COMPUTING AND THE GRID 2ND IEEE/ACM INTERNATIONAL SYMPOSIUM CCGRID2002 BERLIN, GERMANY 21-24 MAY 2002, PISCATAWAY, NJ, USA,IEEE COMPUT. SOC, US, 21 May 2002 (2002-05-21), pages 470-475, XP010592677 ISBN: 0-7695-1582-7**

## Description

### Field of the invention

The present invention is related to industrial systems and in particular to measuring, storing and retransmitting process variables.

### State of the art

Measuring physical properties of a process is of crucial importance to process knowledge, description and control, automation, quality monitoring and control, hazard and risk control and improving comfort and safety. Typically these measurements are done using analog sensors, resistors dependent on the physical property, thermocouples, piezo elements, electromagnetic generators or electric pulse generating mechanisms, each connected to an appropriate transmitter or signal conditioner and then connected to the analog input of a controller. Each sensor is connected through its own cable to the controller. The controller requires an input for each sensor attached to it. This makes the installation expensive and modifications to the installation difficult as for each sensor added, additional cables and input hardware are needed.

In some cases analog signals may be digitized near the sensor and transmitted to the controller over a bus system. In this case the cabling is simplified but any modification to the system requires software modification in the controller to access the added sensors. In many cases, the property needing to be measured does not vary rapidly so there is no need to measure it frequently. This creates an opportunity to limit costs.

The need can arise to design more flexible systems having a limited number of cables, a flexible cabling method and flexible number of sensors. The reasons therefore can be numerous:

- Experience and new insight in a process can show that additional measurements can increase product quality, increase level of comfort, increase ease of regulation, increase efficiency or decrease power consumption.
- Back-up sensors can be required to assure production continuity during main sensor calibration or failure
- Building extensions, machine upgrades or capacity increases can require the addition of sensors to existing installations.

**[0004b]** In *'Wireless Distributed Sensing and Actuation', B. Costa, document for Bachelor of Engineering, October 2002,* the feasibility is explored of developing wireless smart sensor modules conformant to the IEEE1451 standard. Each such module comprises a temperature sensor. This implies that certain hardware components must be present in each individual module, which clearly renders the implementation of a full sensor network not very cost-efficient. A further drawback is that the smart sensor described in this document cannot draw its power from the network.

**[0004c]** In *'Application Note 212, Autoconfiguration of 1-Wire Modular Systems', Dallas Maxim, August 2002,* a method tor identifying the geographical location of a 1-Wire node on a 1-Wire network is described. For each location at least two modes are required. The 1-Wire bus must maintain a table with the geographical locations of the fixed nodes. A bus master cannot read the network to completely identify a network without additional data.

### Aims of the invention

The present invention aims to provide easy and reliable connection of a flexible number of sensors for measuring different physical properties to a computer network in order to view or log these properties or to use in process control. The present invention thus aims to provide a more flexible measurement system for physical properties, the system having a limited number of cables, a flexible cabling method and flexible number of sensors.

### Summary of the invention

The present invention concerns a measurement system arranged to measure physical values over a bus type network, said network comprising at least one networkable sensor, wherein said system comprises an embedded PC arranged as a bridge device between said network and a computer network connection, and wherein said bridge device is connectable to a multitude of simultaneously accessible network branches. In the measurement system according to the present invention, preferably up to eight network branches can be connected. Preferably, the bridge device comprises an I/O port configured as a byte wide input port and a byte wide output port. A network branch can be associated with a unique bit position on the I/O port. The unique bit position of the input and output port on the I/O are advantageously combined to drive one sensor network.

The computer network connection is preferably configured for UDP and/or HTTP communication.

Further, the bridge device can comprise a file transfer utility. Also, the bridge device can further comprise a software method arranged to configure the bridge device for use with a specific sensor on a network branch. Said software method is preferably specific for a type of sensor. The software method advantageously comprises calibration of the sensor using calibration data stored in said sensor.

Another aspect of the present invention concerns a method for communicating with a network of sensors, comprising the steps of:

- Providing a measurement system of the present invention comprising a bridge device and at least one sensor network branch,

- Associate each network branch with a bit position on an I/O port on the bridge device configured as a byte wide input port and a byte wide output port, and

- Using said bit position for addressing data to a specific branch.

Another aspect of the present invention concerns a method for automatically initialising and configuring a measurement system according to the present invention, comprising the steps of:

- Providing a measurement system according to the present invention,

- Attributing a bit position in the I/O port to each network branch,

- Reading data stored on each sensor

- Determining the sensor type for each sensor, and

- Associating a software method stored on the bridge device to each sensor.

In another aspect of the present invention, a method for calibrating a sensor, comprising the step of storing calibration information in the sensor is disclosed.

## Short description of the drawings

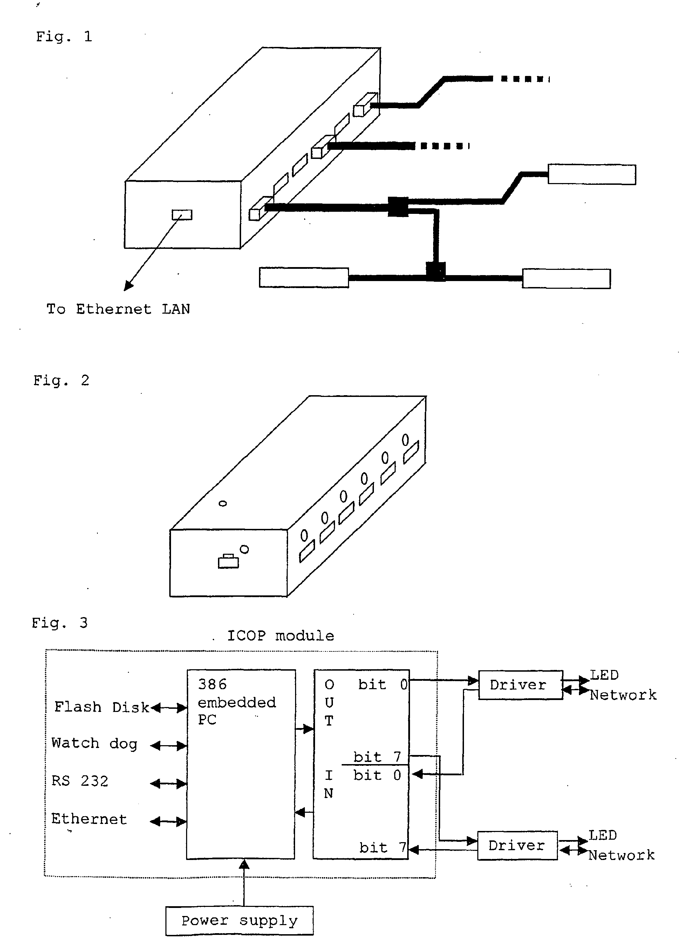

Fig. 1 represents a system lay-out according to the present invention wherein up to eight temperature network branches can be connected to one bridge device. The number of sensors connected to one branch is limited mainly by cable length. Both UDP and HTTP are supported on one Ethernet connection.

Fig. 2 represents a detailed view of the bridge device.

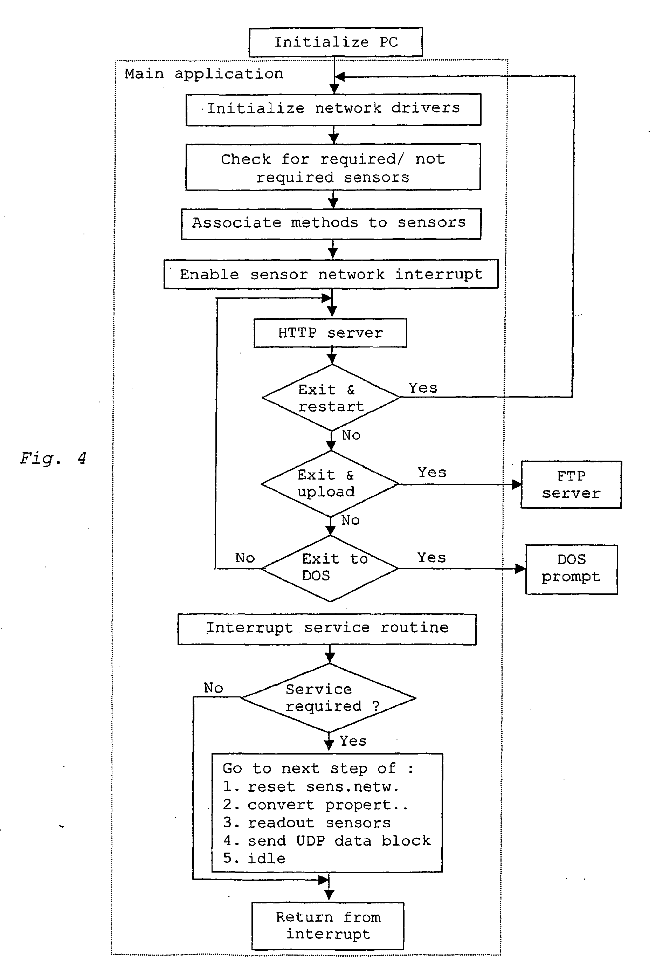

Fig. 3 shows the bridge device architecture.

Fig. 4 draws a software flow chart for use with a system according to the present invention.

## Detailed description of the invention

The present invention is related to the hardware, the software and the method required to measure physical properties over a bus type network and make them available to a controlling device as if they were connected directly to it. The number of sensors is limited by the bandwidth of the bus. This invention also describes how the capacity of the network connecting the sensors can be quadrupled or octupled without creating additional timing delays.

To achieve a high degree of flexibility, sensor calibration data can be stored in the sensor's memory. A bridge device connects the sensor network to the Ethernet using an UDP protocol for fast transmission of data to UDP capable controllers such as PLCs and using a TCP protocol for HTTP capable devices such as a web browser.

When using the UDP protocol, the property data is transmitted on a regular basis. To a PLC this data stream can act as a substitution for one or more analog input modules. An input module allows the connection of a well-defined number of sensors. Because this is not true for a networked measurement, flexibility is enhanced in the latter configuration.

Through the UDP protocol the measured data can be sent to external logging devices or to a SCADA package for visualization.

When using the HTTP protocol the sensor's data can be visualized for inspection or debugging of a process. This happens in parallel to the normal interface to the PLC and does not interfere with it. A simple web browser is sufficient to show all the readings of the physical properties being measured over the bus. This method of communication allows diagnosis and customization of the networked sensor measurements.

The system uses two main hardware components:

the sensor and the embedded PC acting as a bridge (bridge device) between network types. Sensors are networkable sensors, such as e.g. 1-Wire™ sensors known in the art.

The software consists of three main components: the operating system, the main application and a file transfer utility.

The electric cable connecting the sensors to the bridge device, the sensor network, comprises a data line, a ground line and a supply voltage line.

The sensors

Within the context of the present invention, the term sensor refers to a single device capable of sensing a physical property and converting this property into digital information. The sensor input is the physical property, its output is digital data transmitted on the sensor network. The format of this data is such that it allows the bridge device to convert the data into a correctly scaled and labeled measurement of the physical property without setting any parameters in the bridge device.

To achieve this, the bridge device contains a number of software methods. During initialization one software method is automatically associated to each sensor based on information retrieved from the sensor during the initialization process. Software methods can be specific for one type of sensor, e.g. cold junction compensation and linearisation of a thermocouple output signal, or can be generic, using fixed or variable parameters. If variable parameters are used, these parameters are retrieved from the sensor during initialization. This implies that the sensor contains a non-volatile storage for this information.

Consider following as an example of a simple generic method with a variable parameter. The calculation is performed in the bridge device, the variable parameter, scale_factor, is retrieved from the sensor during initialization, the register content is continually retrieved from the sensor after digitizing the physical property:

$$physical\_property = scale\_factor \times register\_content$$

*DC Voltage and current measurement*

Electric DC voltage or current can be measured preferably with a Dallas One Wire™ device used in battery monitoring applications. Such devices have one to three voltage inputs with different ranges. A resistor network can be used to correctly scale the physical property to the input range of the A/D converter. To calculate the voltage or current a method with variable parameters is used, taking into account the resistor values.

*Ratiometric analog transducers*

Some transducers require an electric excitation in order to measure a physical property. The output signal of the transducer is proportional to both the physical property and the excitation voltage or current. The excitation is derived from the bus' power line. The excitation and output signals can be measured preferably with a Dallas One Wire™ device used in battery monitoring applications. Such devices have one to three voltage inputs with different ranges. Current measurements are obtained by using a combination of a shunt resistor and a low-voltage input. These devices also contain a temperature sensor that is used by the method to correct the sensor's output for temperature drift.

*Analog output transducers*

This type of transducer can be treated as ratiometric transducers without excitation. If the transducer is a thermocouple, the Dallas One Wire™ device's internal temperature measurement can be used for cold junction compensation.

*Pulse generating transducers*

Some transducers produce a number of electric pulses proportional to a given quantity; e.g. mass flow, volume flow, energy flow, number of rotations. These are preferably measured with a Dallas One Wire™ counter IC. One counter input to this circuit is connected to the transducer output, counting the number of pulses, the second input is connected to a fixed frequency reference signal to allow accurate conversion of quantity to rate, e.g. flow rate, power or rotational speed.

*The temperature sensor*

The temperature measurement is preferably done by a Dallas One Wire™ device where the temperature reading is available in a digital format.

The sensor can e.g. be inserted in a dead-ended stainless steel tube with an outer diameter of 1/4" The length of the tube can be varied according to requirements of the process. This makes the sensor compatible with many existing industrial installations. The sensor is connected to the network via a connector located outside the metal tube. In this way the sensor's housing is galvanically isolated from the network.

The bridge device

The bridge device is an embedded controller based on standard PC architecture, such as manufactured by ICOP. No keyboard, mouse, speaker, display or disk drive is installed. A Flash Prom contains the PC's BIOS and a simulated disk drive used to contain the operating system, the main application, the utilities and the setup data. An additional general purpose I/O (GPIO) port is configured as a byte wide input port and a byte wide output port. The lines associated with bit 0 of the input and output port are combined to drive one sensor network. The same is done for bit 1, bit 2 etc. This creates up to eight sensor networks, called network branches; each of which can have full One Wire™ network specifications. Through the software all these branches appear to the user as one single network with a capacity and throughput eight times higher than that of a traditional One Wire™ network.

Additionally, the bridge module contains the hardware required to power it from the mains and to drive and protect the network. Each network branch is ESD, short circuit and over-voltage protected. A zener barrier can be included to make an entire branch safe for use in hazardous areas.

The operating system

The operating system is a DOS compatible operating system. Because no keyboard or display are installed, DOS routes its input and output to and from the RS232 serial interface. At startup the main application is automatically started. Other operating systems such as linux™ can equally be used.

The main software application

The main application drives the sensor network, transmits the sensor data over UDP protocol and interfaces to the user over HTTP protocol. The application uses a timer interrupt to ensure the network branches are accessed at fixed times and UDP data are sent out. The time needed to perform these two tasks can be determined in advance. The rate at which they are performed is selected in such a way that free time remains for performing the HTTP based communication. The One Wire™ interface and UDP transmissions can be seen as two consecutive high priority tasks within one thread, the HTTP interface can be seen as a low priority task in a second thread. Both threads appear to be running simultaneously in cooperative multitasking; they are created and maintained by the main application.

The One Wire™ interface implements all functions required to identify individual sensors on the temperature measurement network, to check for their presence on the network, to convert and read the registers and to check data integrity.

When more than one network branch is connected, all branches can be accessed simultaneously. If every branch contains the same type of sensor (e.g. a temperature sensor), the same transaction sequence, containing the same number of bits, is required on every branch to complete a temperature conversion and readout cycle. The method for sending n (up to eight) bits on n branches simultaneously is as follows:

1. Each branch is associated with one bit position in the input and the output port register.
2. Determine which branches need to be accessed and set the associated bits in a temporary timing register to 0. Set the other bits to 1.
3. The data bit to be transmitted on a branch is written to the associated bit position of a temporary transmit register. This is repeated for every one of the n bits that need to be transmitted. Set the other bits to 1.
4. The bit timing is initiated by writing the temporary timing register to the output port. Timing is completed as defined by the One Wire™ protocol
5. Instead of writing a single data bit, the whole temporary transmit register is written to the output port.
6. Bit timing is completed as defined by the One Wire™ protocol

The method for simultaneous reception is similar to that for transmission, using a temporary receive register.

When large networks are to be operated with cable lengths exceeding 100 meters per branch, it might be required to use second digital output lines of the bridge device to drive a single network branch, supplying an active pull-up capacity. In this case simultaneous transmission on network branches can still be applied but is limited to four branches.

The bridge device maintains a list of required sensors. When the main application is started the network is scanned for sensors. This list is compared to the list of required sensors. In the UDP data blocks and in the HTTP pages the sensors appear in the order of the required sensors list. Sensors that are in this list but not on the network are explicitly flagged with an error message. Sensors that are on the network but are not on the list of required sensors are appended to the end of the UDP data or HTTP page. The sensors in the list of required sensors can be given a name by the user, making it easier for the user to identify the sensor in relation to the process. The sensors that are detected on the network but that are not in the list of required sensors are given default names.

The list of required sensors is a tool that enables the system to be integrated in an industrial control loop. It allows a PLC that uses the measurements for process control to detect that sensors are missing, not connected or not responding. The error checking function in the main application allows the PLC to detect failing communication or sensors. The list of required sensors can be edited in ASCII format and uploaded to the bridge device's simulated disk via FTP or can be edited directly on the bridge device via a HTTP web page.

If greater accuracy of measurement is required than is specified for the sensor, it can be calibrated individually reducing the error to lower values. A separate software tool performs calibration of sensors. Any number of identical sensors supported by a single bridge device can be calibrated simultaneously. The sensors are installed to measure a precisely known physical property. This property and the values measured by the sensors are recorded. The errors are calculated. This procedure is performed at least three times at different values of the physical property. For each sensor a second order polynomial is calculated using the least squares method. The factors of the terms of each individual polynomial are written to each sensor's EEPROM. When the sensor is moved from one process to another, e.g. from the calibration site or the spare parts stock to the process, the calibration data are immediately and automatically moved along with it. During normal operation, the method, associated with that sensor, corrects the measurement.

The UDP data blocks that are sent from the bridge device to the PLC or controller are sent at fixed intervals. They contain data of the required sensors along with an error status for every sensor. In the PLC or controller a watchdog is used to make sure data arrives as expected and error status is decoded. The combination of required sensors list and error checking in the bridge device and in the controller, makes fault detection at least as reliable as with dedicated PLC or controller hardware.

The file transfer utility

The file transfer utility uses FTP to allow upload of firmware or configuration files from any FTP capable computer.

**Claims**

1. A measurement system arranged to measure physical values over a bus type sensor network, said bus type sensor network comprising at least one networkable sensor, **characterised in that** said measurement system further comprises an embedded PC arranged as a bridge device between said bus type sensor network and a computer network connection, **characterized in that** said bridge device is arranged for being connected to a multitude of simultaneously accessible sensor network branches.

2. The measurement system according to claim 1, wherein up to eight sensor network branches can be connected.

3. The measurement system according to any of the claims 1 to 2, wherein the bridge device comprises an I/O port configured as a byte wide input port and a byte wide output port.

4. The measurement system according to claim 3, wherein a sensor network branch is associated with a unique bit position on the I/O port.

5. The measurement system according to claim 4, wherein the unique bit position of the input and output port on the I/O are dombined to drive a single sensor network branch.

6. The measurement system according to any of the claims 1 to 5, wherein the computer network connection is configured for UDP and/or HTTP communication.

7. The measurement system as in any of the claims 1 to 6, wherein the bridge device further comprises a file transfer utility.

8. The measurement system as in any of the claims 1 to 7, wherein the bridge device further comprises a software method arranged to configure the bridge device for use with a specific sensor on at least one of the sensor network branches.

9. The measurement system as in claim 8, wherein said software method is specific for a type of sensor.

10. The measurement system as in claim 8 or 9, wherein the software method is further arranged for calibration of the sensor using calibration data stored in said sensor.

11. A method for automatically initialising and configuring a measurement system as in any of claims 8 to 10, comprising the steps of:

   • Attributing a bit position in the I/O port to each sensor network branch,
   • Reading data stored on each sensor
   • Determining the sensor type for each sensor, and
   • Associating a software method stored on the bridge device to each sensor.

12. Use of a measurement system as in any of claims 1 to 10 for communicating with a bus type sensor network, said measurement system comprising a bridge device and at least one sensor network branch, by associating each sensor network branch with a bit position on an I/O port on the bridge device, said I/O port being configured as a byte wide input port and a byte wide output port, and using said bit position for addressing data to a specific sensor network branch.

13. Use of a measurement system comprising a software method as in claim 10, for sensor calibration using calibration data stored in said sensor.

**Patentansprüche**

1. Messsystem für das Messen physikalischer Werte über ein busartiges Sensorennetzwerk, wobei das busartige Sensorennetzwerk mindestens einen netzwerkfähigen Sensor umfasst, **dadurch gekennzeichnet, dass** das Messsystem ferner einen eingebetteten PC umfasst, der sich als Bridge-Vorrichtung zwischen dem busartigen Sensorennetzwerk und einer Computernetzwerkverbindung befindet, **dadurch gekennzeichnet, dass** sich die Bridge-Vorrichtung mit mehreren gleichzeitig zugänglichen Sensorennetzwerkverzweigungen verbinden lässt.

2. Messsystem nach Anspruch 1, wobei sich bis zu acht Netzwerkverzweigungen verbinden lassen.

3. Messsystem nach Anspruch 1 oder 2, wobei die Bridge-Vorrichtung einen E/A-Port aufweist, der als Byte-breiter Eingabeport und Byte-breiter Ausgabeport konfiguriert ist.

4. Messsystem nach Anspruch 3, wobei eine Sensorennetzwerkverzweigung einer eindeutigen Bitposition auf dem E/A-Port zugeordnet ist.

5. Messsystem nach Anspruch 4, wobei die eindeutige Bitposition des Eingabe- und Ausgabeports auf dem E/A verknüpft werden, um eine einzige Sensorennetzwerkverzweigung anzutreiben.

6. Messsystem nach einem der Ansprüche 1 bis 5, wobei die Computernetzwerkverbindung für die UDP- bzw: HTTP-Kommunikation konfiguriert ist.

7. Messsystem nach einem der Ansprüche 1 bis 6, wobei die Bridge-Vorrichtung ferner ein Dienstprogramm zur Dateiübertragung umfasst.

8. Messsystem nach einem der Ansprüche 1 bis 7, wobei die Bridge-Vorrichtung ferner ein Softwareverfahren umfasst, das die Bridge-Vorrichtung für die Verwendung mit einem bestimmten Sensor auf mindestens einer der Sensorennetzwerkverzweigungen konfiguriert.

9. Messsystem nach Anspruch 8, wobei das Softwareverfahren für eine Art von Sensor spezifisch ist.

10. Messsystem nach Anspruch 8 oder 9, wobei das Softwareverfahren ferner die Kalibrierung des Sensors mit Hilfe von in dem Sensor gespeicherten Kalibrierungsdaten umfasst.

11. Verfahren zur automatischen Initialisierung und Konfigurierung eines Messsystems nach Anspruch 8 bis 10 umfassend die Verfahrensschritte des

    - Zuordnens einer Bitposition im E/A-Port zu jeder Sensorennetzwerkverzweigung,
    - Lesens der Daten, die in jedem Sensor gespeichert sind,
    - Ermittelns der Art jedes Sensors, und
    - Zuordnens eines in der Bridge-Vorrichtung gespeicherten Softwareverfahrens zu jedem Sensor.

12. Verwendung eines Messsystems nach einem der Ansprüche 1 bis 10 für die Kommunikation mit einem busartigen Sensorennetzwerk, wobei das Messsystem eine Bridge-Vorrichtung und mindestens eine Sensorennetzwerkverzweigung umfasst, durch Verbinden der einzelnen Sensorennetzwerkverzweigungen mit einer Bitposition auf einem E/A-Port auf der Bridge-Vorrichtung, wobei der E/A-Port als Byte-breiter Eingabeport und Byte-breiter Ausgabeport konfiguriert ist, und Verwenden der Bitposition zum Absenden von Daten an eine bestimmte Sensorennetzwerkverzweigung.

13. Verwendung eines Messsystems mit einem Softwareverfahren nach Anspruch 10 für die Kalibrierung des Sensors mit Hilfe der in dem Sensor gespeicherten Kalibrierungsdaten.

**Revendications**

1. Système de mesure conçu pour mesurer des valeurs physiques sur un réseau de capteurs de type bus, ledit réseau de capteurs de type bus comprenant au moins un capteur pouvant fonctionner en réseau, **caractérisé en ce que** ledit système de mesure comprend en outre un PC intégré conçu sous la forme d'un dispositif pont entre ledit réseau de capteurs de type bus et une connexion de réseau informatique, **caractérisé en ce que** ledit dispositif pont est conçu pour être connecté à une multitude de branches de réseau de capteurs accessibles simultanément.

2. Système de mesure selon la revendication 1, dans lequel on peut connecter jusqu'à huit branches de réseau de capteurs.

3. Système de mesure selon l'une quelconque des revendications 1 et 2, dans lequel le dispositif pont comprend un port E/S configuré sous la forme d'un port d'entrée par octet et d'un port de sortie par octet.

4. Système de mesure selon la revendication 3, dans lequel une branche de réseau de capteurs est associée à une seule position binaire sur le port E/S.

5. Système de mesure selon la revendication 4, dans lequel l'unique position binaire des ports d'entrée et de sortie sur le E/S est combinée pour commander une seule branche de réseau de capteurs.

6. Système de mesure selon l'une quelconque des revendications 1 à 5, dans lequel la connexion au réseau informatique est configurée pour une communication UDP et/ou HTTP.

7. Système de mesure selon l'une quelconque des revendications 1 à 6, dans lequel le dispositif pont comprend en outre un utilitaire de transfert de fichiers.

8. Système de mesure selon l'une quelconque des revendication 1 à 7, dans lequel le dispositif pont comprend en outre un procédé logiciel conçu pour configurer le dispositif pont pour une utilisation avec un capteur spécifique sur au moins une des branches du réseau de capteurs.

9. Système de mesure selon la revendication 8, dans lequel ledit procédé logiciel est spécifique à un type de capteur.

10. Système de mesure selon la revendication 8 ou 9, dans lequel le procédé logiciel est en outre conçu pour étalonner le capteur en utilisant des données d'étalonnage stockées dans ledit capteur.

**11.** Procédé pour initialiser et configurer automatiquement un système de mesure comme dans l'une quelconque des revendications 8 à 10, comprenant les étapes suivantes :

- l'attribution d'une position binaire dans le port E/S pour chaque branche de réseau de capteurs,
- la lecture de données stockées sur chaque capteur,
- la détermination du type de capteur pour chaque capteur et
- l'association d'un procédé logiciel stocké sur le dispositif pont à chaque capteur.

**12.** Utilisation d'un système de mesure selon l'une quelconque des revendications 1 à 10 pour communiquer avec un réseau de capteurs de type bus, ledit système de mesure comprenant un dispositif pont et au moins une branche de réseau de capteurs, en associant chaque branche de réseau de capteurs à une position binaire sur un port E/S du dispositif pont, ledit port E/S étant configuré sous la forme d'un port d'entrée par octet et d'un port de sortie par octet et en utilisant ladite position binaire pour adresser des données à une branche de réseau de capteurs spécifique.

**13.** Utilisation d'un système de mesure comprenant un procédé logiciel selon la revendication 10 pour l'étalonnage du capteur à l'aide de données d'étalonnage stockées dans ledit capteur.

Fig. 1

To Ethernet LAN

Fig. 2

Fig. 3

ICOP module

*Fig. 4*

Initialize PC

Main application

Initialize network drivers

Check for required/ not required sensors

Associate methods to sensors

Enable sensor network interrupt

HTTP server

Exit & restart — Yes

No

Exit & upload — Yes → FTP server

No

Exit to DOS — Yes → DOS prompt

No

Interrupt service routine

Service required ? — No

Yes

Go to next step of :
1. reset sens.netw.
2. convert propert..
3. readout sensors
4. send UDP data block
5. idle

Return from interrupt